# EUROPEAN PATENT APPLICATION

(11) **EP 4 654 431 A1**
(43) Date of publication of application: **26.11.2025**
(21) Application number: 25173910.8
(22) Date of filing: 02.05.2025
(51) Int. Cl.: H02J 7/00, B60L 58/22, H01M 10/44, H01M 10/42

(54) **BATTERY DEVICE, OPERATING METHOD THEREOF, AND BATTERY PACK**

(30) Priority: 23.05.2024 KR 20240067000
(71) Applicant: SAMSUNG SDI CO., LTD., Yongin-si, Gyeonggi-do 17084 (KR)
(72) Inventor: BAE, Jeong Guk, 16678 Suwon-si, Gyeonggi-do (KR)
(74) Representative: Gulde & Partner

(57) **Abstract**

A battery device includes a first switch (SW1) connected to an uppermost node of a plurality of battery cells (C) of a battery module (100) that are serially connected, a second switch (SW2) connected to a lowermost node of the plurality of battery cells (C), a capacitor (CAP) connected between the first switch (SW1) and the second switch (SW2), and a processor (200) configured to control an on-off operation of each of the first and second switches (SW1, SW2) to control voltage charging of the capacitor (CAP) by a charging current from the plurality of battery cells (C), wherein a voltage charged in the capacitor (CAP) functions as an operating voltage of the processor (200).

## Description

### BACKGROUND

### 1. Field

Aspects of the present disclosure relate to a technology for generating power of a processor constituting a battery device.

### 2. Description of the Related Art

Secondary batteries are batteries that can be charged and discharged, unlike primary batteries that cannot be recharged. Low-capacity secondary batteries are used in small portable electronic devices such as smartphones, feature phones, laptop computers, digital cameras, and camcorders, and high-capacity secondary batteries are widely used as motor driving power sources, power storage batteries, and the like in hybrid vehicles, electric vehicles, and the like. These secondary batteries include an electrode assembly including a positive electrode and a negative electrode, a case which accommodates the same, and an electrode terminal connected to the electrode assembly.

The above information disclosed in this Background section is for enhancement of understanding of the background of the present disclosure, and therefore, it may contain information that does not constitute the related (or prior) art.

### SUMMARY

Aspects of embodiments of present disclosure are directed to a battery pack that is provided with a battery management system (hereinafter, referred to as a BMS) which measures, monitors, and controls a state of battery cells and a battery module. The BMS is configured to perform a series of control for battery protection based on measured values such as a current, a voltage, and a charge/discharge current, and the like of the battery module, or to perform various functions such as cell balancing for equal charging of battery cells and the like.

Common methods of supplying operating power to a BMS or a master board on which the BMS is mounted include i) a method of supplying operating power through a low-voltage battery (e.g., a lead-acid battery) installed in a vehicle or an external switching mode power supply (SMPS), ii) a method of arranging coin cells in the master board to supply operating power to a memory mounted on the BMS or master board through the coin cells, and iii) a method of regulating (e.g., direct-current (DC)-DC converting) a voltage of a battery pack itself to supply operating power.

In the case of the method of supplying operating power of the BMS through the low-voltage battery or external SMPS, an increase in the unit price of the low-voltage battery or SMPS, defects in the power supply itself, and voltage fluctuations (e.g., power supply voltage drops, jumps, short circuits, noise, and faulty connections) frequently occur, and due to this power instability, normal operation of the BMS cannot be guaranteed, and accordingly, there is a problem in that the battery pack itself is defective.

In the case of the method of supplying operating power of the BMS through the coin cells, an amount of data stored in the memory (e.g., battery impedance, capacity, lifespan, and various measurement values required for calculating the same) may be extremely limited due to the limitation of power which can be output from the coin cells, and furthermore, there is a high possibility of loss of data stored in the memory.

In the case of the method of regulating the voltage of the battery pack itself to supply operating power, in the current technological trend of increasing the voltage of a battery pack (about 1500 V), there are limitations in that power loss occurs due to reduced efficiency of DC-DC conversion and various problems (e.g., increased unit price, restrictions on the distance between elements in the master board) occur due to inner pressure of the master board.

Accordingly, the present disclosure provides an independent power generation topology for a battery pack capable of securing independent and permanent operating power by solving conventional problems of supplying operating power of a BMS or master board of a battery pack through the voltage of a low-voltage battery, an SMPS, coin cells, or the battery pack itself.

However, objects that the present invention intends to achieve are not limited to the above-described objects and other objects that are not described may be clearly understood by those skilled in the art from the following description.

According to some embodiments of the present disclosure, there is provided a battery device including: a first switch connected to an uppermost node of a plurality of battery cells of a battery module that are serially connected; a second switch connected to a lowermost node of the plurality of battery cells; a capacitor connected between the first switch and the second switch; and a processor configured to control an on-off operation of each of the first and second switches to control voltage charging of the capacitor by a charging current from the plurality of battery cells, wherein a voltage charged in the capacitor functions as an operating voltage of the processor.

In some embodiments, the capacitor may be charged by the charging current from the plurality of battery cells flowing through a path connecting the uppermost node, the first switch, the capacitor, the second switch, and the lowermost node.

In some embodiments, the battery module may include the plurality of battery cells, the first switch, the second switch, and the capacitor; and the processor may operate as a master battery management system (BMS) for the battery module.

In some embodiments, a plurality of battery modules, which includes the battery module, may include a first battery module and a second battery module, the plurality of battery modules may be interconnected in such a way that a capacitor of the first battery module and a capacitor of the second battery module are interconnected in parallel, and a path through which the operating voltage of the processor is applied may be provided by a parallel line connection structure of each capacitor of each battery module.

In some embodiments, the processor may be configured to perform an independent power generation operation; and the independent power generation operation may be defined as an operation of specifying a target battery module with a maximum module voltage defined as a voltage difference between the uppermost node and the lowermost node among the plurality of battery modules, and an operation of closing the first and second switches in the target battery module to allow the capacitor in the target battery module to be charged.

In some embodiments, the processor may be configured to determine a charging time of the capacitor in the target battery module based on a module voltage of an other battery module other than the target battery module.

In some embodiments, the processor may be configured to maintain the first and second switches of an other battery module other than the target battery module in an open state while performing the independent power generation operation for the target battery module.

In some embodiments, the processor may be configured to perform the independent power generation operation in response to the charged voltage of each capacitor of each battery module decreases below a preset reference voltage.

In some embodiments, the operating voltage of the processor may be composed of only the charged voltage of the capacitor.

According to some embodiments of the present disclosure, there is provided an operating method of a battery device including: controlling, by a processor, on-off operations of a first switch and a second switch, wherein the first and second switches are respectively connected to an uppermost node and a lowermost node of a plurality of serially connected battery cells of a battery module; charging a capacitor connected between the first switch and the second switch according to the on-off operations of the first and second switches; and providing a voltage charged in the capacitor as an operating voltage of the processor.

In some embodiments, in the charging, the capacitor may be charged by the charging current from the plurality of battery cells flowing through a path connecting the uppermost node, the first switch, the capacitor, the second switch, and the lowermost node.

In some embodiments, the battery module may include the plurality of battery cells, the first switch, the second switch, and the capacitor; and the processor may operate as a master battery management system (BMS) for the battery module.

In some embodiments, a plurality of battery modules, which includes the battery module, may include a first battery module and a second battery module, the plurality of battery modules may be interconnected in such a way that a capacitor of the first battery module and a capacitor of the second battery module are interconnected in parallel, and a path through which the operating voltage of the processor is applied may be provided by a parallel line connection structure of each capacitor of each battery module.

In some embodiments, the controlling may include: specifying, by the processor, a target battery module with a maximum module voltage defined as a voltage difference between the uppermost node and the lowermost node among the plurality of battery modules; and closing, by the processor, the first and second switches in the target battery module, and in the charging, the capacitor in the target battery module is charged.

In some embodiments, the controlling may further include maintaining the first and second switches in an other battery module other than the target battery module in an open state, which is performed by the processor after the specifying.

In some embodiments, the charging may be performed for a charging time determined based on a module voltage of an other battery module other than the target battery module.

In some embodiments, the processor may further include comparing the charged voltage of each capacitor of each battery module and a preset reference voltage before the controlling; and the controlling may start in response to the charged voltage of each capacitor of each battery module decreasing below the preset reference voltage.

According to some embodiments of the present disclosure, there is provided a battery pack including: a battery module including a plurality of battery cells that are serially connected, a first switch connected to an uppermost node of the plurality of battery cells, a second switch connected to a lowermost node of the plurality of battery cells, a capacitor connected between the first switch and the second switch, and a battery monitoring integrated circuit (IC) (BMIC) configured to control an on-off operation of each of the first and second switches; and a master battery management system (BMS) that functions as a higher-level controller of the BMIC and is configured to transmit a switch control signal to the BMIC, wherein the BMIC is configured to control the on-off operation of each of the first and second switches according to the switch control signal received from the BMS, and wherein a voltage charged in the capacitor functions as an operating voltage of the BMS.

In some embodiments, a plurality of battery modules, which includes the battery module, may include a first battery module and a second battery module, the plurality of battery modules may be interconnected in such a way that a capacitor of the first battery module and a capacitor of the second battery module are interconnected in parallel, and a path through which the operating voltage of the BMS is applied may be provided by a parallel line connection structure of each capacitor of each battery module.

In some embodiments, the BMS may be configured to perform an independent power generation operation; and the independent power generation operation may be defined as an operation of specifying a target battery module with a maximum module voltage defined as a voltage difference between the uppermost node and the lowermost node among the plurality of battery modules, and an operation of closing the first and second switches in the target battery module to allow the capacitor in the target battery module to be charged.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings, in which:
FIG. 1 illustrates a battery module according to some embodiments of the present disclosure;
FIGS. 2A and 2B illustrate a battery pack according to some embodiments of the present disclosure;
FIG. 3 illustrates a block diagram of a battery device according to some embodiments of the present disclosure;
FIG. 4 illustrates a circuit of the battery module according to some embodiments of the present disclosure;
FIG. 5 illustrates a charging current flow for charging a capacitor in the battery device according to some embodiments of the present disclosure;
FIG. 6 illustrates a circuit of the battery pack according to some embodiments of the present disclosure; and
FIGS. 7 and 8 illustrate flow charts of an operating method of the battery device according to some embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to their usual or dictionary meanings and should be interpreted as meanings and concepts consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the drawings, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the drawings. It will be understood that the spatially relative terms are intended to encompass different orientations of the device in use or operation in addition to the orientation depicted in the drawings. For example, if the device in the drawings is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, the applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or provided as a plurality.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly interconnected.

Throughout the specification, when "A and/or B" is stated, it means A, B or A and B, unless otherwise stated. That is, "and/or" includes any or all combinations of a plurality of items enumerated. When a range "C to D" is stated, it means C or more and D or less, unless otherwise specified.

Prior to the detailed description of 'an independent power generation topology' focused on in the embodiments set forth below, structures of a battery module and a battery pack applicable to the embodiments will be preferentially described.

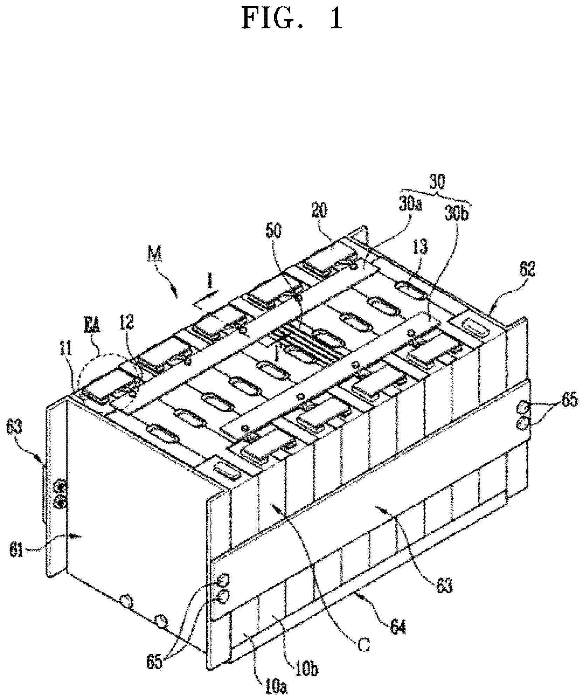

FIG. 1 is a perspective view illustrating the battery module M according to some embodiments of the present disclosure.

Referring to FIG. 1, the battery module M, according to the present disclosure, includes a plurality of battery cells C that include terminal portions 11 and 12 and are arranged in one direction, a connection tab 20 that connects a battery cell 10a and an adjacent battery cell 10b, and a protection circuit module 30 of which one end portion is connected to the connection tab 20. The protection circuit module 30 may be a battery management system (BMS). In addition, the connection tab 20 includes a body portion in contact with the terminal portions 11 and 12 between adjacent battery cells 10a and 10b, and an extension portion that extends from the body portion 22 and is connected to the protection circuit module 30. The connection tab 20 may be a busbar.

The battery cell C may include a battery case, and an electrode assembly and an electrolyte accommodated in the battery case. The electrode assembly and the electrolyte electrochemically react with each other to generate energy. The terminal portions 11 and 12 electrically connected to the connection tab 20 and a vent 13, which is a discharge passage for gas generated inside of the battery cell C, may be provided at one side of the battery cell C. The terminal portions 11 and 12 of the battery cell 10 may be a positive electrode terminal 11 and a negative electrode terminal 12 having different polarities. The terminal portions 11 and 12 of adjacent battery cells 10a and 10b may be electrically connected in series or parallel by the connection tab 20 to be described below. Although an example of serial connection has been described above, the present disclosure is not limited to such a structure, and of course, various line connection structures can be adopted as needed. In addition, the number and arrangement of the battery cells C are not limited to the structure shown in FIG. 1 and may be changed as needed.

The plurality of battery cells C may be arranged in one direction such that wide surfaces (i.e., the wide sides) of the battery cells C face each other, and the plurality of arranged battery cells C may be fixed together (e.g., attached to one another) by housings 61, 62, 63, and 64. The housings 61, 62, 63, and 64 may include a pair of end plates 61 and 62 facing the wide surfaces of the battery cells 10, and side plates 63 and a bottom plate 64 that connect the pair of end plates 61 and 62. The side plate 63 may support a side surface of the battery cell 10, and the bottom plate 64 may support a bottom surface of the battery cell 10. In addition, the pair of end plates 61 and 62, the side plate 63, and the bottom plate 64 may be connected by members such as bolts 65 or the like.

The protection circuit module 30 may be mounted with electronic components and protection circuits and may be electrically connected to the connection tab 20 to be described below. The protection circuit module 30 may include a first protection circuit module 30a and a second protection circuit module 30b that extend at different positions in a direction in which the plurality of battery cells C are arranged (i.e., the side-stacking direction of the plurality of battery cells C). In such examples, the first protection circuit module 30a and the second protection circuit module 30b may be spaced a certain interval apart (e.g., a set distance away from) from each other, may be positioned parallel to each other, and may each be electrically connected to the connection tab 20 adjacent thereto. For example, the first protection circuit module 30a may be formed to extend at one upper side of the plurality of battery cells C in the direction in which the plurality of battery cells C are arranged, and the second protection circuit module 30b may be formed to extend at the other upper side of the plurality of battery cells C in the direction in which the plurality of battery cells C are arranged. The second protection circuit module 30b may be positioned to be spaced a certain interval apart from the first protection circuit module 30a with the vent 13 interposed therebetween and may be disposed parallel to the first protection circuit module 30a. In this way, two protection circuit modules are disposed in parallel and spaced apart from each other in the direction in which the plurality of battery cells C are arranged, thereby reducing (e.g., minimizing) an area of a printed circuit board (PCB) constituting the protection circuit module. That is, the protection circuit module is provided as two separate protection circuit modules, thereby reducing (e.g., minimizing) an unnecessary PCB area. The first protection circuit module 30a and the second protection circuit module 30b may be interconnected by a conductive connection member 50. In such examples, one side of the connection member 50 may be connected to the first protection circuit module 30a, and the other side thereof may be connected to the second protection circuit module 30b so that an electrical connection may be made between the two protection circuit modules.

The connection may be performed through any one method of soldering, resistance welding, laser welding, and projection welding methods.

The connection member 50 may be, for example, an electrical wire. In addition, the connection member 50 may be made of an elastic or flexible material. Through the connection member 50, it is possible to check and manage whether the voltage, temperature, and current of the plurality of battery cells C are normal. That is, information about a voltage, a current, a temperature, or the like received by the first protection circuit module from the connection tabs adjacent thereto and information about voltage, current, temperature, or the like received by the second protection circuit module from the connection tabs adjacent thereto may be integrally managed through the connection member 50 by the protection circuit module 30.

In addition, when the battery cell C swells, an impact is absorbed due to the elasticity or flexibility of the connection member 50, thereby preventing or substantially reducing damage to the first and second protection circuit modules 30a and 30b.

In addition, the shape and structure of the connection member 50 are not limited to that shown in FIG. 1.

In this way, the protection circuit module 30 is provided as the first and second protection circuit modules 30a and 30b, the area of the PCB constituting the protection circuit module can be reducing (e.g., minimized), thereby securing a space inside the battery module M. Thus, a fastening operation of connecting the connection tab 20 and the protection circuit module 30 may be facilitated, and also repair may be facilitated when an abnormality is detected in the battery module M, thereby improving (e.g., increasing) operation efficiency.

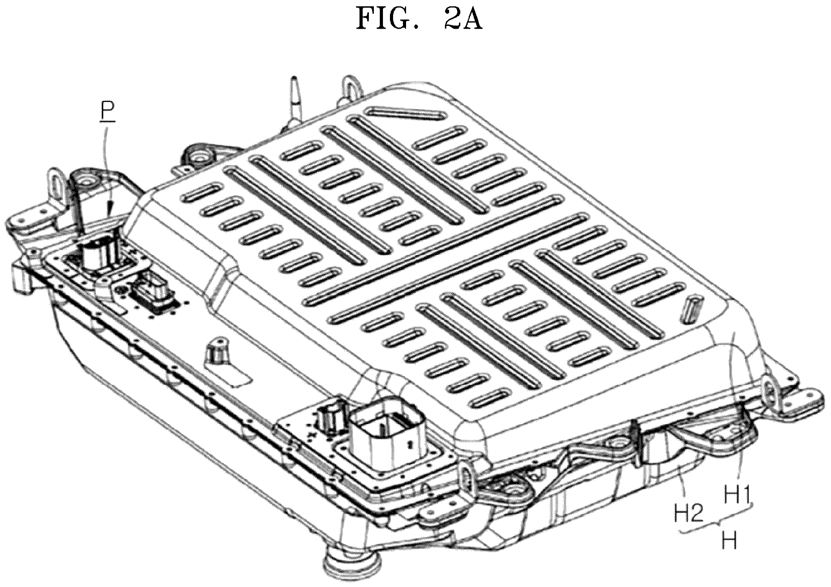

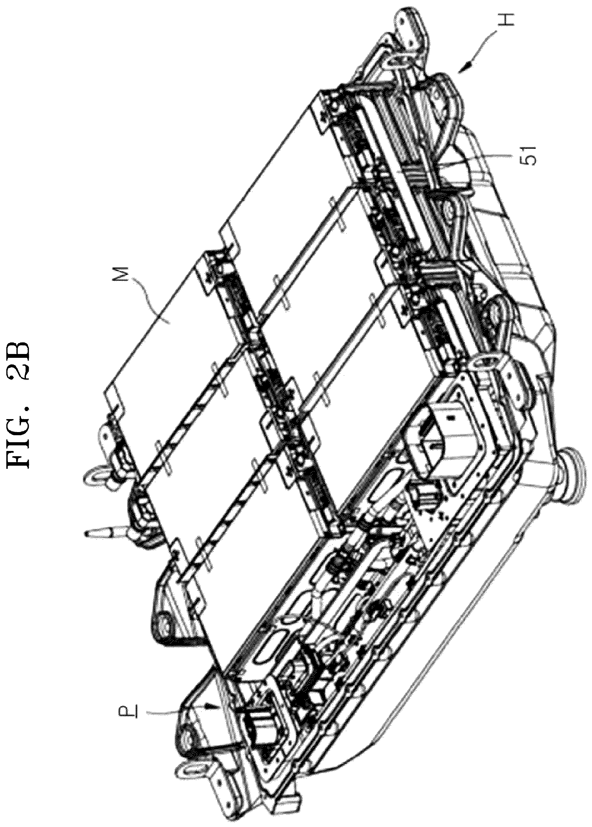

FIGS. 2A and 2B illustrate the battery pack P according to some exemplary embodiments of the present disclosure.

The battery pack P may include a plurality of battery modules M and a housing H for accommodating the plurality of battery modules M. For example, the housing H may include first and second housings H1 and H2 that are coupled to face each other with the plurality of battery modules M interposed therebetween. The plurality of battery modules M may be electrically interconnected using a busbar 51, and the plurality of battery modules M may be electrically interconnected in series, in parallel, or in a series-parallel combination scheme to obtain the desired electrical output power.

The battery pack may include a battery and a battery management system (BMS) for managing the battery. The battery management system may include a detection device, a balancing device, and a control device. The battery module may include a plurality of cells interconnected in series and/or parallel. The battery modules may be interconnected in series and/or in parallel.

The detection device may detect a state of a battery (e.g., voltage, current, temperature, etc.) to output state information indicating the state of the battery. The detection device may detect the voltage of each cell constituting the battery or of each battery module. The detection device may detect current flowing through each battery module constituting the battery module or the battery pack. The detection device may also detect the temperature of a cell and/or module at at least one point of the battery and/or an ambient temperature.

The balancing device may perform a balancing operation of a battery module and/or cells constituting the battery module. The control device may receive state information (e.g., voltage, current, temperature, etc.) of the battery module from the detection device. The control device may monitor and calculate the state of the battery module (e.g., voltage, current, temperature, state of charge (SOC), life span (state of health (SOH)), etc.) on the basis of the state information received from the detection device. In addition, on the basis of the monitored state information, the control device may perform a control function (e.g., temperature control, balancing control, charge/discharge control, etc.) and a protection function (e.g., over-discharge, over-charge, over-current protection, short circuit, fire extinguishing function, etc.). In addition, the control device may perform a wired or wireless communication function with an external device of the battery pack (e.g., a higher level controller or vehicle, charger, power conversion system, etc.).

The control device may control the charging/discharging operation and protection operation of the battery. To this end, the control device may include a charge/discharge control unit, a balancing control unit, and/or a protection unit.

The battery management system is a system that monitors the battery state and performs diagnosis and control, communication, and protection functions, and may calculate the charge/discharge state, calculate battery life or state of health (SOH), cut off, as necessary, battery power (e.g., relay control), control thermal management (e.g., cooling, heating, etc.), perform a high-voltage interlock function, and/or may detect and/or calculate insulation and short circuit conditions.

A relay may be a mechanical contactor that is turned on and off by the magnetic force of a coil or a semiconductor switch, such as a metal oxide semiconductor field effect transistor (MOSFET).

The relay control has a function of cutting off the power supply from the battery if (or when) a problem occurs in the vehicle and the battery system and may include one or more relays and pre-charge relays at the positive terminal and the negative terminal, respectively.

In the pre-charge control, there is a risk of inrush current occurring in the high-voltage capacitor on the input side of the inverter when the battery load is connected. Thus, to prevent or substantially reduce inrush current when starting a vehicle, the pre-charge relay may be operated before connecting the main relay and the pre-charge resistor may be connected.

The high-voltage interlock is a circuit that uses a small signal to detect whether or not all high-voltage parts of the entire vehicle system are connected and may have a function of forcibly opening a relay if (or when) an opening occurs at even one location on the entire loop.

The functions of the above-described BMS serve as basic functions for implementing the operation of a second processor 200 to be described below.

Based on the above description, the operation of a battery device of the embodiments will be described below in further detail.

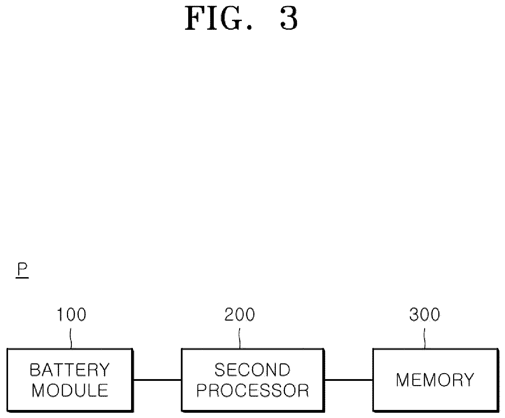

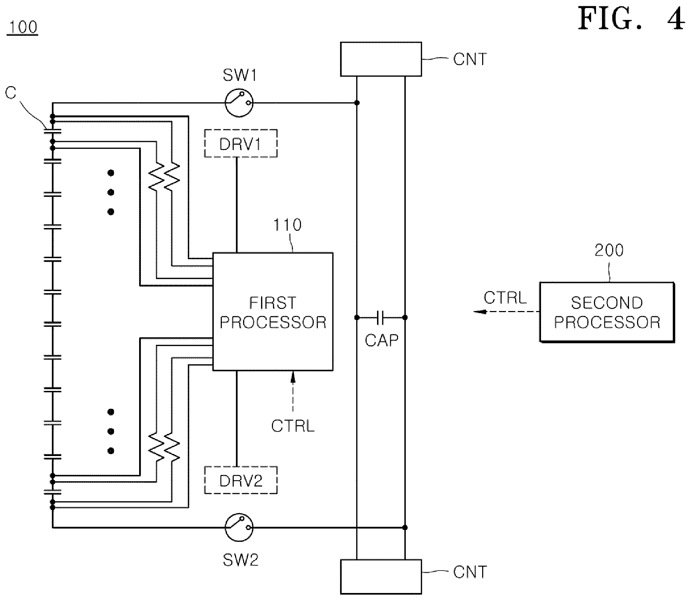

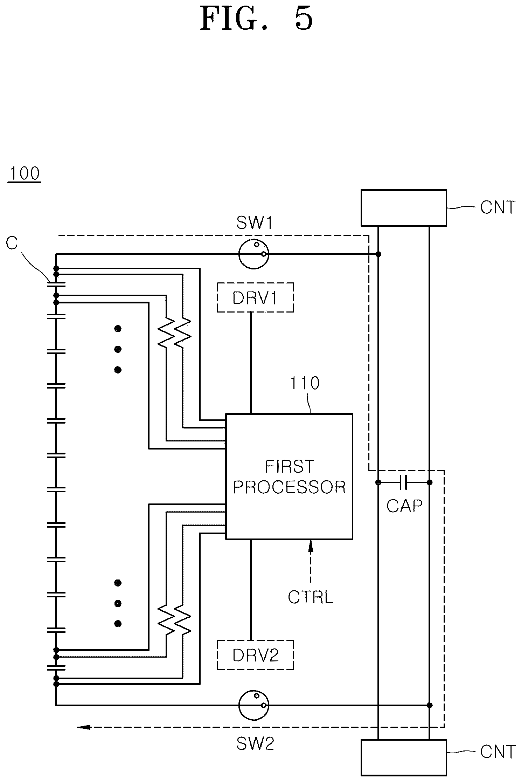

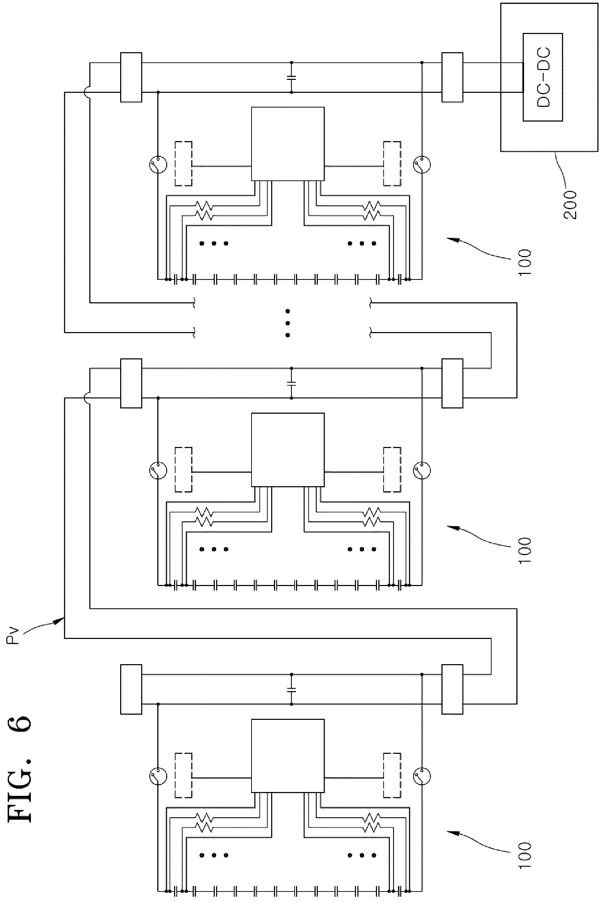

FIG. 3 is a block diagram of the battery device according to some embodiments of the present disclosure, FIG. 4 is an exemplary diagram of a circuit of the battery module according to some embodiments of the present disclosure, FIG. 5 is an exemplary diagram of a charging current flow for charging a capacitor in the battery device according to some embodiments of the present disclosure, and FIG. 6 is an exemplary diagram of a circuit of the battery pack according to some embodiments of the present disclosure.

Referring to FIG. 3, the battery device according to some embodiments may include a battery module 100, the second processor 200, and a memory 300, and each component 100, 200, and 300 together may configure a battery pack P. The battery module indicated by the reference number '100' corresponds to the same configuration as the battery module indicated by the reference letter 'M' in FIGS. 1 and 2.

In order to clearly distinguish terms, first and second processors 110 and 200 will be preferentially defined. The first processor 110 may correspond to a battery monitoring integrated circuit (IC) (BMIC) constituting the battery module 100 to be described below, and may operate to monitor states such as a current and a voltage of each battery cell included in the battery module 100. In some embodiments, the first processor 110 may locally control on-off operations of the first and second switches SW1 and SW2 (i.e., control at a level of the battery module 100) through control of first and second switch drivers DRV1 and DRV2 to be described below.

The second processor 200 may correspond to a master battery management system (BMS), which functions as a higher-level controller of the first processor 110. The second processor 200 may monitor a module voltage of each of the plurality of battery modules 100, and may transmit a control command CTRL to the first processor 110 according to a monitoring result of the module voltage to allow the first processor 110 to control the on-off operations of the first and second switches SW1 and SW2. The second processor 200 may globally control (i.e., control at a battery pack level) the on-off operations of the first and second switches SW1 and SW2 through the first processor 110. As will be described below, a voltage charged in a capacitor CAP of the battery module 100 may function as an operating voltage of the second processor 200, and a step-down DC-DC converter for generating the operating voltage of the second processor 200 (i.e., an internal voltage of the master board) by receiving a charged voltage of the capacitor CAP and step-down DC-DC converting the charged voltage may be mounted in the second processor 200. It should be noted that 'a processor' described in the claims of the present application may correspond to the second processor 200.

At least one command executed by the second processor 200 may be stored in the memory 300. The memory 300 may be implemented as a volatile storage medium and/or a nonvolatile storage medium, for example, may be implemented as a read only memory (ROM) and/or a random access memory (RAM). The memory may be implemented to form the BMS along with the second processor 200.

Next, the battery module 100 will be described with reference to FIG. 4. Referring to FIG. 4, the battery module 100 may include a plurality of serially connected battery cells C, first and second switches SW1 and SW2, first and second switch drivers DRV1 and DRV2, a capacitor CAP, and the above-described first processor 110.

The first switch SW1 may correspond to a high-side switch connected to an uppermost node of the plurality of battery cells C (e.g., a positive electrode node of an uppermost cell among the plurality of battery cells C. Hereinafter, shortened to the uppermost node), and the second switch SW2 may correspond to a low-side switch connected to a lowermost node of the plurality of battery cells C (e.g., a negative electrode node of a lowermost cell among the plurality of battery cells C; hereinafter, referred to as the lowermost node). The first and second switches SW1 and SW2 may be implemented as suitable switch elements such as relays or field-effect transistors (FETs).

The first and second switch drivers DRV1 and DRV2 may correspond to driver ICs, which respectively drive the on-off operations of the first and second switches SW1 and SW2 under the control of the first processor 110.

The capacitor CAP may be connected between the first switch SW1 and the second switch SW2. One node (i.e., one terminal) of the capacitor CAP may be connected to a node other than the node connected to the uppermost node among both nodes of the first switch SW1, and the other node (i.e., the other terminal) of the capacitor CAP may be connected to a node other than the node connected to the lowermost node among both nodes of the second switch SW2. Accordingly, as shown in FIG. 5, based on a state in which the first and second switches SW1 and SW2 are closed, a closed circuit connecting the plurality of battery cells C, the uppermost node, the first switch SW1, the capacitor CAP, the second switch SW2, and the lowermost node may be configured, and a topology in which the voltage of the capacitor CAP is charged by a charging current drawn out from the plurality of battery cells C flowing in the closed circuit configured as described above may be implemented. The voltage charged in the capacitor CAP of the battery module 100 may function as the operating voltage of the second processor 200. The capacitance of the capacitor CAP may be predefined by a designer based on specifications of the battery pack system, such as the magnitude of the operating voltage and the capacity of the battery cell C desired for the second processor 200.

As shown in FIG. 6, a plurality of battery modules 100 may be provided, and the plurality of battery modules 100 and the second processor 200 may constitute the battery pack. When any two battery modules 100 among the plurality of battery modules 100 are defined as first and second battery modules and a line connection structure thereof is described, the first and second battery modules may be connected in such a way that the capacitor CAP of the first battery module and the capacitor CAP of the second battery module may be interconnected in parallel through a connector CNT. A path through which the operating voltage of the second processor 200 is applied (hereinafter, referred to as a voltage application path PV) may be provided by the parallel line connection structure of each capacitor CAP of each battery module 100.

As mentioned above, some embodiments focus on a configuration of securing an independent and permanent operating voltage of the BMS of the battery pack (i.e., the second processor 200), and based on the above description, hereinafter, a topology adopted to secure the independent power of the second processor 200 will be described in further detail.

First, the second processor 200 may specify the battery module 100 (hereinafter, referred to as a target battery module) with the maximum module voltage defined as a voltage difference between the uppermost node and the lowermost node among the plurality of battery modules 100. (Here, it is assumed that an operating voltage for performing the initial operation of the second processor 200 is already secured. For example, when power of the first battery pack system is turned on, an example in which the first processor 110 included in an uppermost battery module 100 closes the first and second switches SW1 and SW2 so that a voltage is charged in the capacitor CAP, and the charged voltage of the capacitor CAP is used in the initial operation of the second processor 200 may be provided).

When the target battery module is specified, the second processor 200 transmits a switch closing control command CTRL to the first processor 110 included in the target battery module, and accordingly, the first processor 110 of the target battery module may operate to close the first and second switches SW1 and SW2 through the first and second switch drivers DRV1 and DRV2. Accordingly, the flow of charging current shown in FIG. 5 may occur to charge the capacitor CAP included in the target battery module. The voltage charged in the capacitor CAP of the target battery module may be transmitted to the second processor 200 through the voltage application path PV, and the operating voltage of the second processor 200 may be generated by the step-down DC-DC converter of the second processor 200.

According to the above configuration, a topology in which the capacitor CAP is charged using the plurality of battery cells C included in the battery module 100 with the maximum module voltage, and only the voltage charged in the capacitor CAP is utilized as the operating voltage of the second processor 200 may be prepared. That is, because the above-mentioned target battery module corresponds to the battery module 100 with a larger module voltage than the other battery module, and an overcharged amount of the module voltage of the target battery module compared to the other battery module should be inevitably discharged for module balancing, in this embodiment, a configuration in which the overcharged amount of the voltage formed in the target battery module, which is a target of discharge, is utilized as the operating voltage of the second processor 200 is adopted. Accordingly, as the operating voltage of the second processor 200 (i.e., the BMS) is supplied from the plurality of battery cells C included in the battery module 100, an independent power generation topology for the BMS which does not utilize a separate low-voltage battery, the SMPS, the coin cells, or the voltage of the battery pack itself may be provided, and voltage balancing between the battery modules 100 may be naturally performed without a separate discharging operation in a process of generating the independent power of the BMS.

When "an operation of specifying the target battery module with the maximum module voltage defined as the voltage difference between the uppermost node and the lowermost node among the plurality of battery modules 100, and an operation of closing the first and second switches SW1 and SW2 included in the specified target battery module to allow the capacitor CAP included in the target battery module to be charged" is defined as an independent power generation operation, the second processor 200 may be configured to determine a charging time of the capacitor CAP included in the target battery module based on the module voltage of the other battery module other than the target battery module when the independent power generation operation is performed.

For example, the above-mentioned independent power generation operation performs a voltage balancing function between the battery modules 100 along with a function of securing the operating voltage of the second processor 200, and because the voltage of the plurality of battery cells C included in the target battery module decreases as the charging time of the capacitor CAP included in the target battery module increases, a phenomenon in which the module voltage of the target battery module is lower than the module voltage of the other battery modules may occur. In order to prevent or substantially reduce the likelihood of this voltage imbalance phenomenon between the battery modules 100, the second processor 200 may operate to limit a module voltage drop of the target battery module due to current withdrawal from the plurality of battery cells C to the module voltage of the other battery module.

In order to implement the above operation of limiting the module voltage drop, the second processor 200 may determine the charging time of the capacitor CAP included in the target battery module based on the module voltage of the other battery module, and then may perform the charging operation of the capacitor CAP of the target battery module only for the determined charging time. The charging time of the capacitor CAP of the target battery module may correspond to the time required for the module voltage of the target battery module to decrease to the module voltage of the other battery module (e.g., an average value of the module voltages of other battery modules), and the second processor 200 may operate to determine the charging time of the capacitor CAP based on parameters such as the capacitance of the capacitor CAP, the module voltage difference between the target battery module and the other battery module, and a C-rate of the plurality of battery cells C of the target battery module. As used herein, the C-rate of a battery cell may refer to a measurement that indicates how fast a battery cell can be charged or discharged relative to its rated capacity. Thus, a higher C-rate may indicate a faster charge or discharge, while a lower C-rate may indicate a slower one

In such examples, the second processor 200 may control the first processor 110 of the other battery module to maintain the first and second switches SW1 and SW2 included in the other battery module other than the target battery module in an open state while performing the independent power generation operation for the target battery module. That is, when the capacitor CAP of the other battery module is also charged at the same time as a process in which the capacitor CAP is charged for the charging time determined for the target battery module, an additional voltage imbalance between the plurality of battery modules 100 may be caused, and in order to prevent or substantially reduce the likelihood of this additional voltage imbalance, the second processor 200 may prevent the voltage charging operation of the capacitor CAP from being performed for the other battery module.

In order to continuously maintain the operating voltage of the second processor 200, the second processor 200 may be configured to perform the independent power generation operation when the charged voltage of each capacitor CAP of each battery module 100 decreases below a preset reference voltage. That is, after the independent power generation operation is completed, both the first and second switches SW1 and SW2 of each battery module 100 are maintained in the open state, and accordingly, the charged voltage of each capacitor CAP of each battery module 100 decreases. In order to prevent or substantially reduce the likelihood of a situation in which the capacitor CAP is completely discharged and thus the operating voltage of the second processor 200 cannot be supplied, the second processor 200 may be configured to always monitor the charged voltage of the capacitor CAP, and may perform the above-described independent power generation operation again when the charged voltage of the capacitor CAP decreases below the reference voltage.

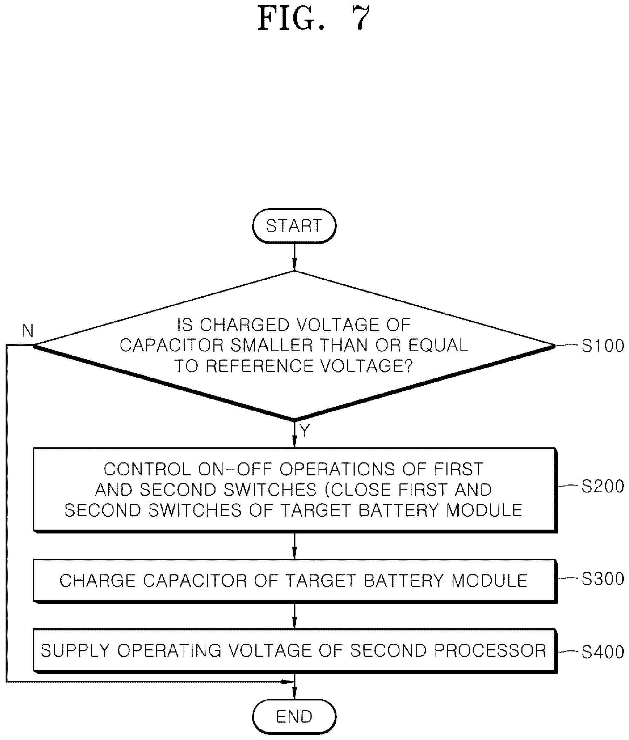

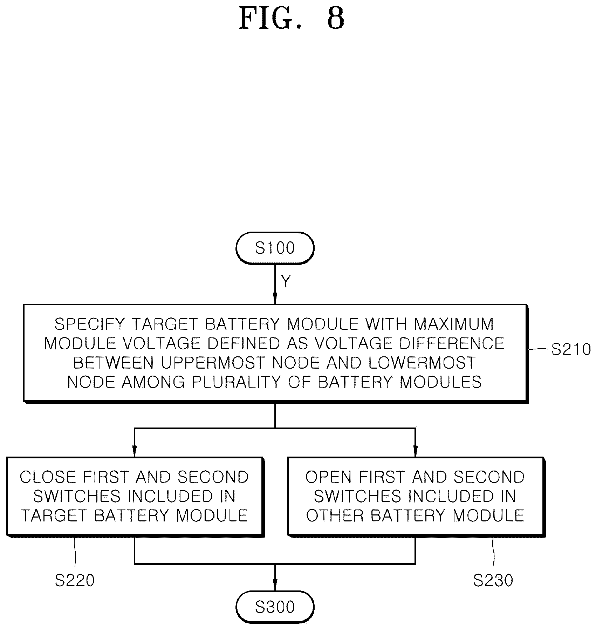

FIGS. 7 and 8 are flow charts of an operating method of the battery device according to some embodiments of the present disclosure. The operating method of the battery device according to some embodiments will be described with reference to FIGS. 7 and 8, and the detailed description of configurations overlapping the above-described content may be omitted and the description may primarily focus on time-series configurations.

First, the second processor 200 monitors the charged voltage of each capacitor CAP of each battery module 100 and compares the monitored charged voltage of the capacitor CAP with a preset reference voltage (S100).

When it is determined that the charged voltage of the capacitor CAP has decreased below the reference voltage in operation S100, the second processor 200 controls the on-off operations of the first and second switches SW1 and SW2 through a method of transmitting the control command CTRL to the first processor 110 (S200). As shown in FIG. 8, in operation S200, the processors specify the target battery module with the maximum module voltage defined as the voltage difference between the uppermost node and the lowermost node among the plurality of battery modules 100 (S210), and close the first and second switches SW1 and SW2 included in the target battery module specified in operation S210 (S220). In such examples, the second processor 200 maintains the first and second switches SW1 and SW2 included in the other battery module other than the target battery module in an open state (S230). Operations S220 and S230 are parallel processes which are independently performed, and the order of their execution is not limited to the above-described order.

According to the on-off operations of the first and second switches SW1 and SW2 in operation S200, the capacitor CAP connected between the first switch SW1 and the second switch SW2 is charged (S300). In operation S300, the capacitor CAP included in the target battery module specified in operation S210 is charged. The charging operation of the capacitor CAP in operation S300 is performed for a charging time determined based on the module voltage of the other battery module other than the target battery module.

The voltage charged in the capacitor CAP through operation S300 is provided as the operating voltage of the second processor 200 through the above-described voltage application path PV (S400).

Thus, according to some embodiments of the present disclosure, as a configuration in which a voltage of a battery module is selectively charged to a capacitor based on an on-off control of the switch provided in the battery module, and the voltage charged in the capacitor is supplied as an operating voltage of a battery management system (BMS) or master board is adopted, it is possible to configure a battery pack capable of securing an independent and permanent operating voltage without utilizing a voltage of a low-voltage battery, a switching mode power supply (SMPS), coin cells, or the battery pack itself.

Further, as a configuration in which a voltage is drawn out from a target battery module with a maximum module voltage among a plurality of battery modules and the voltage is supplied as an operating voltage of a BMS or master board is adopted, because an independent and permanent operating voltage is secured and module balancing for the battery module can be performed, reliable operation of a battery pack can be ensured.

However, effects that can be achieved through the present invention are not limited to the above-described effects and other effects that are not described may be clearly understood by those skilled in the art from the detailed descriptions.

The embodiments described herein may be implemented, for example, as a method or process, a device, a software program, a data stream, or a signal. Although discussed in the context of a single type of implementation (e.g., discussed only as a method), features discussed herein may also be implemented in other forms (e.g., a device or a program). The device may be implemented by suitable hardware, software, firmware, and the like. The method may be implemented on a device, such as a processor that generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

Although the present disclosure has been described with reference to embodiments and drawings illustrating aspects thereof, the present disclosure is not limited thereto. Various suitable modifications and variations can be made by a person skilled in the art to which the present disclosure belongs within the technical scope of the present disclosure as defined by the appended claims and their equivalents.

## Claims

1. A battery device comprising:
a first switch (SW1) connected to an uppermost node of a plurality of battery cells (C, 10, 10a) of a battery module (M, 100) that are serially connected;
a second switch (SW2) connected to a lowermost node of the plurality of battery cells (C, 10, 10a);
a capacitor (CAP) connected between the first switch (SW1) and the second switch (SW2); and
a processor (200) configured to control an on-off operation of each of the first and second switches (SW1, SW2) to control voltage charging of the capacitor (CAP) by a charging current from the plurality of battery cells (C, 10, 10a),
wherein a voltage charged in the capacitor (CAP) functions as an operating voltage of the processor (200).

2. The battery device of claim 1, wherein the capacitor (CAP) is charged by the charging current from the plurality of battery cells (C, 10, 10a) flowing through a path (PV) connecting the uppermost node, the first switch (SW1), the capacitor (CAP), the second switch (SW2), and the lowermost node.

3. The battery device of claim 1 or 2, wherein:
the battery module (M, 100) comprises the plurality of battery cells (C, 10, 10a), the first switch (SW1), the second switch (SW2), and the capacitor (CAP); and
the processor (200) operates as a master battery management system, BMS, for the battery module (M, 100).

4. The battery device of claim 3, wherein:
a plurality of battery modules (M, 100), which comprises the battery module (M, 100), comprises a first battery module (M, 100) and a second battery module (M, 100),
the plurality of battery modules (M, 100) are interconnected in such a way that a capacitor (CAP) of the first battery module (M, 100) and a capacitor (CAP) of the second battery module (M, 100) are interconnected in parallel, and
a path (PV) through which the operating voltage of the processor (200) is applied is provided by a parallel line connection structure of each capacitor (CAP) of each battery module (M, 100).

5. The battery device of claim **4,** wherein:
the processor (200) is configured to perform an independent power generation operation; and
the independent power generation operation is defined as an operation of specifying a target battery module (M, 100) with a maximum module voltage defined as a voltage difference between the uppermost node and the lowermost node among the plurality of battery modules (M, 100), and an operation of closing the first and second switches (SW1, SW2) in the target battery module (M, 100) to allow the capacitor (CAP) in the target battery module (M, 100) to be charged.

6. The battery device of claim 5, wherein the processor (200) is configured to determine a charging time of the capacitor (CAP) in the target battery module (M, 100) based on a module voltage of an other battery module (M, 100) other than the target battery module (M, 100).

7. The battery device of claim 5 or 6, wherein the processor (200) is configured to maintain the first and second switches (SW1, SW2) of an other battery module (M, 100) other than the target battery module (M, 100) in an open state while performing the independent power generation operation for the target battery module (M, 100).

8. The battery device of any one of claims 5 to 7, wherein the processor (200) is configured to perform the independent power generation operation in response to the charged voltage of each capacitor (CAP) of each battery module (M, 100) decreases below a preset reference voltage.

9. The battery device of any one of the preceding claims, wherein the operating voltage of the processor (200) is composed of only the charged voltage of the capacitor (CAP).

10. An operating method of a battery device, the method comprising:
controlling, by a processor (200), on-off operations of a first switch (SW1) and a second switch (SW2), wherein the first and second switches (SW1, SW2) are respectively connected to an uppermost node and a lowermost node of a plurality of serially connected battery cells (C, 10, 10a) of a battery module (M, 100);
charging a capacitor (CAP) connected between the first switch (SW1) and the second switch (SW2) according to the on-off operations of the first and second switches (SW1, SW2); and
providing a voltage charged in the capacitor (CAP) as an operating voltage of the processor (200).

11. The operating method of claim 10, wherein:
the battery module (M, 100) comprises the plurality of battery cells (C, 10, 10a), the first switch (SW1), the second switch (SW2), and the capacitor (CAP); and
the processor (200) operates as a master battery management system, BMS, for the battery module (M, 100),
wherein:
a plurality of battery modules (M, 100), which comprises the battery module (M, 100), comprises a first battery module (M, 100) and a second battery module (M, 100),
the plurality of battery modules (M, 100) are interconnected in such a way that a capacitor (CAP) of the first battery module (M, 100) and a capacitor (CAP) of the second battery module (M, 100) are interconnected in parallel, and
a path (PV) through which the operating voltage of the processor (200) is applied is provided by a parallel line connection structure of each capacitor (CAP) of each battery module (M, 100).

12. The operating method of claim 11, wherein the controlling comprises:
specifying, by the processor (200), a target battery module (M, 100) with a maximum module voltage defined as a voltage difference between the uppermost node and the lowermost node among the plurality of battery modules (M, 100); and
closing, by the processor (200), the first and second switches (SW1, SW2) in the target battery module (M, 100), and
in the charging, the capacitor (CAP) in the target battery module (M, 100) is charged.

13. The operating method of claim 12, wherein the controlling further comprises maintaining the first and second switches (SW1, SW2) in an other battery module (M, 100) other than the target battery module (M, 100) in an open state, which is performed by the processor (200) after the specifying.

14. The operating method of claim 12 or 13, wherein the charging is performed for a charging time determined based on a module voltage of an other battery module (M, 100) other than the target battery module (M, 100).

15. A battery pack (P) comprising:
a battery module (M, 100) comprising a plurality of battery cells (C, 10, 10a) that are serially connected, a first switch (SW1) connected to an uppermost node of the plurality of battery cells (C, 10, 10a), a second switch (SW2) connected to a lowermost node of the plurality of battery cells (C, 10, 10a), a capacitor (CAP) connected between the first switch (SW1) and the second switch (SW2), and a battery monitoring integrated circuit, IC, BMIC, configured to control an on-off operation of each of the first and second switches (SW1, SW2); and
a master battery management system, BMS, that functions as a higher-level controller of the BMIC and is configured to transmit a switch control signal to the BMIC,
wherein the BMIC is configured to control the on-off operation of each of the first and second switches (SW1, SW2) according to the switch control signal received from the BMS, and
wherein a voltage charged in the capacitor (CAP) functions as an operating voltage of the BMS.
